# EUROPEAN PATENT APPLICATION

(11) **EP 4 484 618 A1**
(43) Date of publication of application: **01.01.2025**
(21) Application number: 22928987.1
(22) Date of filing: 28.12.2022
(51) Int. Cl.: C30B 29/36, C30B 25/18, H01L 21/304, H01L 21/66

(54) **METHOD FOR SUPPRESSING FORMATION OF STACKING FAULT, STRUCTURE PRODUCED BY THIS METHOD, AND METHOD FOR EVALUATING AFFECTED LAYER**

(30) Priority: 24.02.2022 JP 2022027319
(71) Applicant: Kwansei Gakuin Educational Foundation, Nishinomiya-shi, Hyogo 662-8501 (JP); Toyota Tsusho Corporation, Nagoya-shi Aichi 450-8575 (JP)
(72) Inventor: KANEKO, Tadaaki, Sanda-shi, Hyogo 669-1330 (JP); DOJIMA, Daichi, Sanda-shi, Hyogo 669-1330 (JP); TODA, Kohei, Sanda-shi, Hyogo 669-1330 (JP); SASAKI, Jun, Sanda-shi, Hyogo 669-1330 (JP); KOJIMA, Kiyoshi, Tokyo 108-8208 (JP)
(74) Representative: Schön, Christoph
(86) International application number: PCT/JP2022/048627
(87) International publication number: WO 2023/162472

(57) **Abstract**

The problem to be solved is to provide a new technology capable of suppressing the formation of stacking faults. The problem to be solved is to provide a new technology capable of suppressing stacking defects formed during epitaxial growth on a semiconductor substrate. The present invention is a method for suppressing formation of stacking faults, comprising a subsurface damaged layer removal step S10 of removing a subsurface damaged layer 11 of a semiconductor substrate 10, a crystal growth step S20 of performing crystal growth on a surface from which the subsurface damaged layer11 is removed.

## Description

### Technical Field

The present invention relates to a method for suppressing formation of stacking faults, a structure prepared by the method, and an evaluation method of a subsurface damaged layer.

### Background Art

Usually, a semiconductor substrate is manufactured by slicing an ingot of a semiconductor material. On a surface of the sliced semiconductor substrate, there is a surface layer (hereinafter, referred to as a subsurface damaged layer) including crystal distortion, cracks and the like introduced at the time of slicing. In order not to lower yield in a process of device manufacturing, it is necessary to planarize the substrate surface while removing the subsurface damaged layer.

In order to achieve removal and planarization of the subsurface damaged layer, various methods have been developed according to physical properties of the semiconductor material. For example, in silicon carbide (SiC), which is a compound semiconductor, reduction of a subsurface damaged layer and planarization of a substrate subsurface are performed by performing multi-stage mechanical grinding and polishing.

Patent Literature 1 discloses reducing a subsurface damaged layer and planarizing a substrate surface through a rough grinding step using abrasive grains of diamond and the like, a finish grinding step using abrasive grains having a particle size smaller than that of the abrasive grains used in the rough grinding step, and a chemical mechanical polishing (CMP) step of performing polishing using a mechanical action of a polishing pad and a chemical action of slurry in combination.

### Citation List

### Patent Literature

Patent Literature 1: JP 2015-5702 A

### Summary of Invention

### Technical Problem

In order to improve reliability of a semiconductor device (device), it is desirable that various crystal defects and stacking faults (SF) present in an epitaxial layer grown on a semiconductor substrate have low density. Especially, the stacking faults are regarded as a cause of voltage abnormality in a power device, and it is necessary to form the epitaxial layer having few stacking faults.

An object of the present invention is to provide a novel technology capable of suppressing formation of stacking faults.

An object of the present invention is to provide a novel technology capable of suppressing in-growth stacking faults formed during epitaxial growth on a semiconductor substrate.

### Solution to Problem

The present invention that solves the above-described problem is a method for suppressing formation of stacking faults, the method including a subsurface damaged layer removal step of removing a subsurface damaged layer of a semiconductor substrate, and a crystal growth step of performing crystal growth on a surface from which the subsurface damaged layer is removed.

In a preferred mode of the present invention, the subsurface damaged layer removal step is a step of removing the subsurface damaged layer introduced by performing machining.

In a preferred mode of the present invention, the subsurface damaged layer removal step is a step of etching the semiconductor substrate.

In a preferred mode of the present invention, the subsurface damaged layer removal step is a step of removing 1.5 um or more from the surface of the semiconductor substrate.

In a preferred mode of the present invention, the subsurface damaged layer removal step is a step of removing 6.0 um or more from the surface of the semiconductor substrate.

In a preferred mode of the present invention, the semiconductor substrate is silicon carbide.

The present invention also relates to an evaluation method of a subsurface damaged layer. That is, the present invention that solves the above-described problem is an evaluation method of a subsurface damaged layer, the method including an evaluation step of evaluating a subsurface damaged layer of a semiconductor substrate based on in-growth stacking faults formed during epitaxial growth on the semiconductor substrate.

In a preferred mode of the present invention, the evaluation step includes an etching step of etching the subsurface damaged layer of the semiconductor substrate, a crystal growth step of performing crystal growth on a surface on which the subsurface damaged layer is etched, and a measurement step of measuring density of in-growth stacking faults at the crystal growth step.

In a preferred mode of the present invention, the evaluation step is a step of performing measurement a plurality of times while changing an etching depth.

In a preferred mode of the present invention, the etching step includes a first etching step of etching at a first etching depth and a second etching step of etching at a second etching depth.

### Advantageous Effects of Invention

According to the disclosed technology, it is possible to provide a novel technology of suppressing formation of stacking faults.

According to the disclosed technology, it is possible to provide a novel technology capable of suppressing in-growth stacking faults formed during epitaxial growth on a semiconductor substrate.

Other problems, features, and advantages will be apparent by reading the description of embodiments described below when taken in conjunction with the drawings and claims.

### Brief Description of Drawings

Fig. 1 is an illustrative diagram for illustrating a method for suppressing formation of stacking faults according to the present invention.
Fig. 2 is an illustrative diagram for illustrating a conventional method.
Fig. 3 is an illustrative diagram for illustrating an etching step in an example and comparative examples.
Fig. 4 is an illustrative diagram for illustrating a crystal growth step in the example and comparative examples.
Fig. 5 is a graph illustrating a relationship between in-growth stacking faults IGSFs and an etching depth ED according to the example and comparative examples.

### Description of Embodiments

Hereinafter, preferred embodiments of a method for suppressing formation of stacking faults, a structure prepared by the method, and an evaluation method of a subsurface damaged layer according to the present invention is described in detail with reference to the accompanying drawings. The technical scope of the present invention is not limited to the embodiments illustrated in the accompanying drawings, and can be appropriately changed within the scope recited in claims. In the present specification, in the notation of a Miller index, "-" means a bar corresponding to an index immediately after the same, and "-" is added before the index to express a negative index. Note that, in the following description of the embodiments and the accompanying drawings, the same reference sign is given to the similar configuration, and redundant description is omitted.

### <<Method for Suppressing Formation of Stacking Faults>>

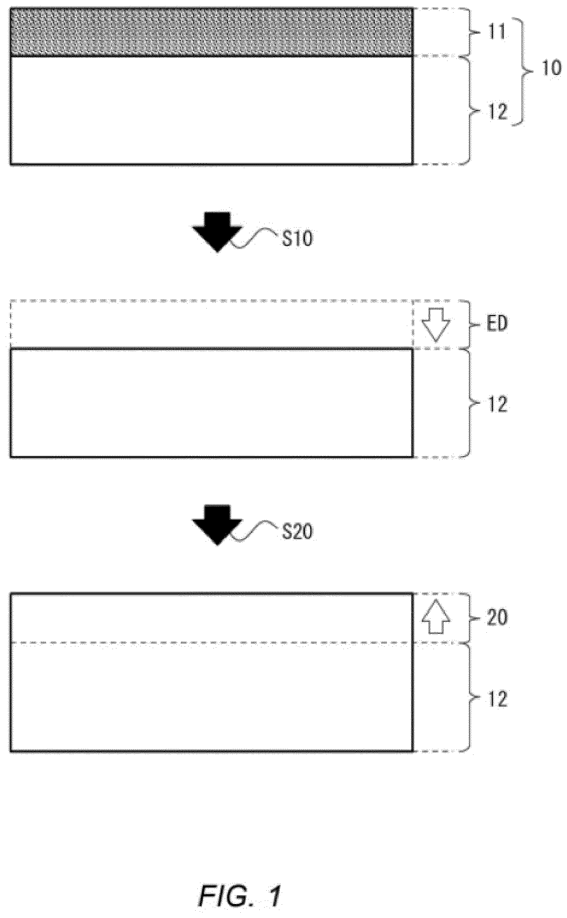

As illustrated in Fig. 1, the method for suppressing formation of stacking faults according to the present invention includes a subsurface damaged layer removal step S10 of removing a subsurface damaged layer 11 of a semiconductor substrate 10, and a crystal growth step S20 of allowing crystal growth of a growth layer 20 on a surface from which the subsurface damaged layer 11 is removed.

The present invention includes the subsurface damaged layer removal step S10 of removing the subsurface damaged layer 11, thereby making it possible to suppress formation of in-grown stacking faults (IGSFs). That is, it is considered that the in-growth stacking faults IGSFs are formed because the subsurface damaged layer 11 remains on the surface of the semiconductor substrate 10.

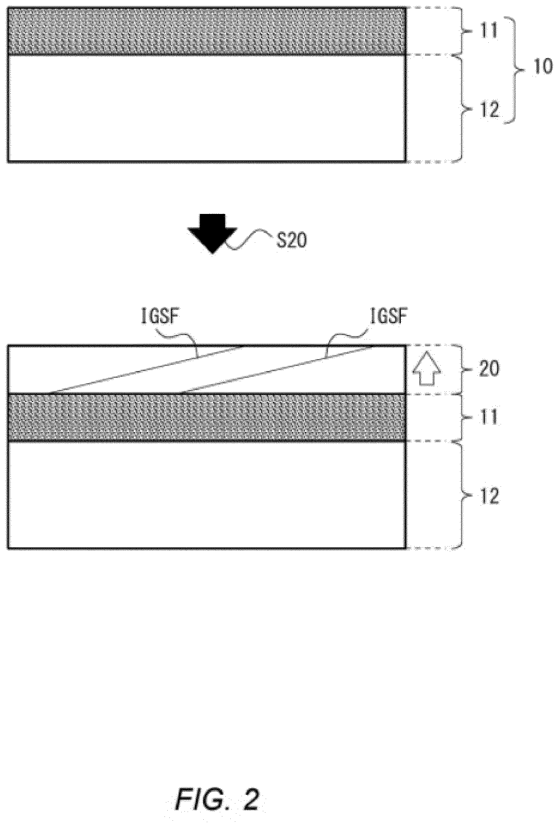

Fig. 2 is a conceptual diagram in a case where the crystal growth step S20 is performed on the surface of the semiconductor substrate 10 on which the subsurface damaged layer 11 remains. Fig. 2 illustrates a state in which the in-growth stacking faults IGSFs are generated in the growth layer 20 from an interface between the semiconductor substrate 10 and the growth layer 20 in a case where the subsurface damaged layer 11 remains.

Note that, the "subsurface damaged layer" in the present specification refers to a layer introduced by performing machining on the surface of the semiconductor substrate 10. Whether or not the "subsurface damaged layer" is removed can be confirmed by performing epitaxial growth on the semiconductor substrate 10 from which the subsurface damaged layer 11 is removed and observing and evaluating the in-growth stacking faults IGSFs in the growth layer 20.

As a material of the semiconductor substrate 10, any commonly used material can be naturally adopted. The semiconductor material includes, for example, a known group IV material such as silicon (Si), germanium (Ge), and diamond (C). The material of the semiconductor substrate 10 includes, for example, a known group IV-IV compound semiconductor material such as silicon carbide (SiC). The material of the semiconductor substrate 10 includes a known group II-VI compound semiconductor material such as zinc oxide (ZnO), zinc sulfide (ZnS), zinc selenide (ZnSe), cadmium sulfide (CdS), or cadmium telluride (CdTe). The material of the semiconductor substrate 10 includes, for example, a known group III-V compound semiconductor material such as boron nitride (BN), gallium arsenide (GaAs), gallium nitride (GaN), aluminum nitride (AlN), indium nitride (InN), gallium phosphide (GaP), indium phosphide (InP), and indium antimonide (InSb). The material of the semiconductor substrate 10 includes, for example, a known oxide semiconductor material such as aluminum oxide (Al₂O₃) and gallium oxide (Ga₂O₃). Note that, the semiconductor substrate 10 may have a configuration in which known additive atoms used according to the material thereof are appropriately added.

Note that, as a preferable material of the semiconductor substrate 10 used in the present invention, the above-described compound semiconductor can be exemplified. For example, a compound semiconductor such as single-crystal SiC is a hard-brittle material and is classified as a material of which processing is extremely difficult. The method according to the present invention can suppress the formation of the in-growth stacking faults IGSFs by removing the subsurface damaged layer 11 before the growth of the growth layer 20 of the compound semiconductor.

### <Subsurface Damaged Layer Removal Step S10>

Hereinafter, the subsurface damaged layer removal step S10 according to the present invention is described in detail.

The subsurface damaged layer removal step S10 is a step of removing the subsurface damaged layer 11 introduced onto the surface of the semiconductor substrate 10 by a step accompanied by machining such as slicing, rough grinding, finish grinding, and chemical mechanical polishing. In other words, this is a step of removing the subsurface damaged layer 11 of the semiconductor substrate 10 to expose a bulk layer 12.

By performing the subsurface damaged layer removal step S10 also on the semiconductor substrate 10 after the chemical mechanical polishing step, it is possible to remove the subsurface damaged layer 11 that causes the in-growth stacking faults IGSFs.

As a method for removing the subsurface damaged layer 11, thermal etching can be adopted. As the thermal etching, for example, H₂ etching, Si vapor pressure etching, sublimation etching and the like can be adopted.

An etching depth ED from the surface of the semiconductor substrate 10 at the subsurface damaged layer removal step S10 increases or decreases depending on the depth (thickness) of the subsurface damaged layer 11 introduced into the semiconductor substrate 10; this is preferably 0.5 um or more, more preferably 1.0 um or more, still more preferably 1.5 um or more, still more preferably 2.0 um or more, still more preferably 3.0 um or more, still more preferably 4.0 um or more, still more preferably 5.0 um or more, and still more preferably 6.0 um or more.

In a region in which the subsurface damaged layer 11 is present, the formation of the in-growth stacking faults IGSFs formed during epitaxial growth is suppressed as an etching amount is increased (that is, the etching depth ED becomes deeper). In a state in which the subsurface damaged layer 11 is removed and the bulk layer 12 is exposed, the formation of the in-growth stacking faults IGSFs is almost zero. Therefore, the depth of the subsurface damaged layer 11 introduced into the semiconductor substrate 10 can be evaluated by obtaining the etching depth ED at which the formation of the in-growth stacking faults IGSFs is almost zero.

### <Crystal Growth Step S20>

Hereinafter, the crystal growth step S20 according to the present invention is described in detail.

The crystal growth step S20 is a step of forming the growth layer 20 by performing the epitaxial growth on the surface of the semiconductor substrate 10 from which the subsurface damaged layer 11 is removed at the subsurface damaged layer removal step S10.

As a method for forming the growth layer 20, for example, a known film forming method such as a physical vapor deposition method (PVD method) and a chemical vapor deposition method (CVD method) can be adopted.

Density of the in-growth stacking faults IGSFs in the growth layer 20 is preferably 3.0 faults/cm² or less, more preferably 2.0 faults/cm² or less, still more preferably 1.0 fault/cm² or less, and even more preferably almost 0 faults/cm².

As a method for measuring presence or absence and density of the in-growth stacking faults IGSFs, a known method used for detecting the stacking faults SFs, such as a photoluminescence (PL) method, transmission or reflection X-ray topography (XRT), dislocation evaluation by chemical etching, and Raman spectroscopy, can be adopted.

The method for suppressing formation of stacking faults according to the present invention includes the subsurface damaged layer removal step S10 of removing the subsurface damaged layer 11, thereby making it possible to suppress the in-growth stacking faults IGSFs formed during the epitaxial growth.

According to the method for suppressing the formation of the stacking faults according to the embodiment, the subsurface damaged layer removal step S10 is a step of removing the subsurface damaged layer 11 introduced by performing machining. The subsurface damaged layer removal step S10 is a step of removing the subsurface damaged layer 11 introduced by performing the chemical mechanical polishing step.

By the method for suppressing the formation of the stacking faults according to the embodiment, it is possible to manufacture the semiconductor substrate in which the density of the in-growth stacking faults IGSFs is low. By the method for suppressing the formation of the stacking faults according to the embodiment, it is possible to manufacture a semiconductor device in which the density of the in-growth stacking faults IGSFs is low. Note that, the semiconductor device includes, for example, a Schottky barrier diode, a junction barrier Schottky diode, a thyristor, a bipolar junction transistor, and a PiN diode.

### <<Evaluation Method of Subsurface Damaged Layer>>

The evaluation method of the subsurface damaged layer according to the present invention includes an evaluation step of evaluating the subsurface damaged layer 11 of the semiconductor substrate 10 on the basis of the in-growth stacking faults IGSFs of the semiconductor substrate 10. Note that, components basically the same as the components described in the embodiment described above are denoted by the same reference signs, and the description thereof is simplified.

In a case where the subsurface damaged layer 11 is present on the interface between the semiconductor substrate 10 and the growth layer 20, the in-growth stacking faults IGSFs are generated in the growth layer 20 due to the subsurface damaged layer 11 (refer to Fig. 2).

Therefore, it is possible to evaluate whether the subsurface damaged layer 11 remains in the semiconductor substrate 10 by forming the growth layer 20 on the semiconductor substrate 10 to be evaluated and evaluating the in-growth stacking faults IGSFs.

The evaluation step according to the embodiment includes an etching step of etching the subsurface damaged layer 11 of the semiconductor substrate 10, a crystal growth step of performing crystal growth on a surface on which the subsurface damaged layer 11 is etched, and a measurement step of measuring the density of the in-growth stacking faults IGSFs at the crystal growth step.

As a method for measuring presence or absence and density of the in-growth stacking faults IGSFs at the measurement step S30, a known method used for detecting the stacking faults SFs, such as a photoluminescence (PL) method, transmission or reflection X-ray topography (XRT), dislocation evaluation by chemical etching, and Raman spectroscopy, can be adopted.

The evaluation step according to the embodiment includes a step of performing measurement a plurality of times while changing the etching depth ED. That is, the semiconductor substrate 10 to be evaluated is subjected to the etching step so as to have different etching depths ED, and then subjected to the crystal growth step and the measurement step. By evaluating a correspondence relationship between such different etching depths ED and the density of the in-growth stacking faults IGSFs, the depth of the subsurface damaged layer 11 remaining in the semiconductor substrate 10 to be evaluated can be obtained.

### Examples

Hereinafter, the present invention is described more specifically on the basis of an example and comparative examples. Note that, the present invention is not limited to the following contents.

As a substrate used in the following example and comparative examples, a substrate cut out to a size of 25 mm × 10 mm from a 4H-SiC wafer after chemical mechanical polishing inclined by four degrees in a <11-20> direction was used. In other words, the substrates used in the example and comparative examples were cut out from the same CMP finished wafer.

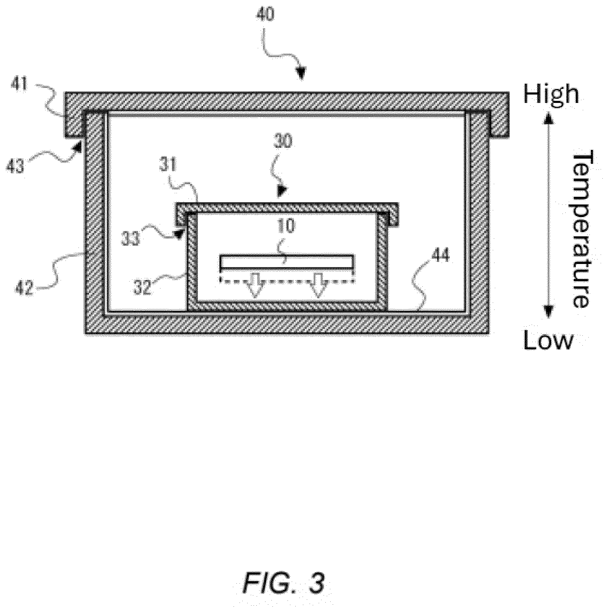

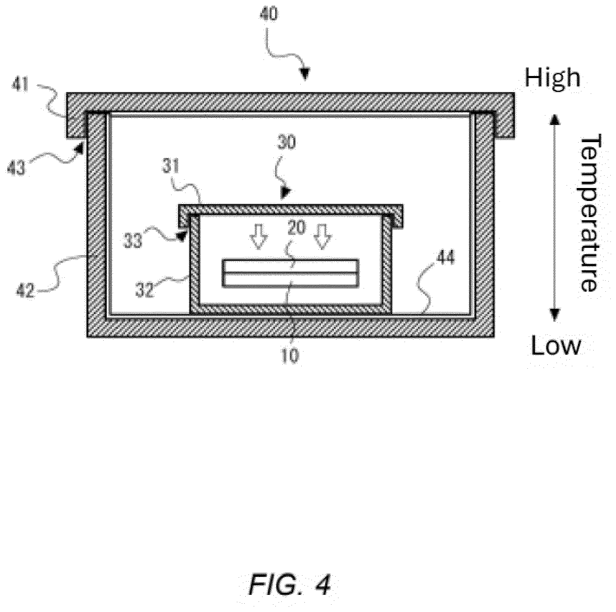

A device used in the following example and comparative examples was the device disclosed in WO 2021/025085 provided with a main container 30, a refractory material container 40, and a heating furnace capable of housing the main container 30 and the refractory material container 40 and of heating in such a manner that a temperature gradient is formed. (Refer to Figs. 3 and 4).

### (Main Container 30)

It is only required that the main container 30 be configured to be able to house a semiconductor substrate 10 and generate vapor pressures of gas phase species containing a Si element and gas phase species containing a C element in an internal space during heat treatment. For example, the main container 30 is formed of a material containing SiC, and is preferably formed of a material containing polycrystalline SiC. The main container 30 preferably has a mode in which SiC is exposed on at least a part of a container inner surface.

In the embodiment illustrated in Figs. 3 and 4, an entire main container 30 is formed of polycrystalline SiC. By heating the main container 30 formed of such material, the vapor pressures of the gas phase species containing the Si element and the gas phase species containing the C element can be generated in the main container 30.

That is, it is desirable that an environment in the heat-treated main container 30 be a vapor pressure environment of a mixed system of the gas phase species containing the Si element and the gas phase species containing the C element. As the gas phase species containing the Si element, Si, Si₂, Si₃, Si₂C, SiC₂, and SiC can be exemplified. As the gas phase species containing the C element, Si₂C, SiC₂, SiC, and C can be exemplified. That is, a SiC-based gas is present in the main container 30.

Note that, when it is configured to generate the vapor pressures of the gas phase species containing the Si element and the gas phase species containing the C element in the internal space at the time of heat treatment of the main container 30, the structure may be adopted. For example, there may be a configuration in which polycrystalline SiC is exposed on a part of the inner surface, a configuration in which polycrystalline SiC is separately arranged in the main container 30 and the like.

As illustrated in Figs. 3 and 4, the main container 30 is a fitting container including an upper container 31 and a lower container 32 that can be fitted to each other. A minute gap 33 is formed in a fitting portion between the upper container 31 and the lower container 32, and it is configured that the inside of the main container 30 can be exhausted (evacuated) from the gap 33. That is, it is configured that the inside of the main container 30 is a semi-closed space at the time of exhaust.

The "semi-closed space" in the present specification refers to a space in the container that can be evacuated and can confine at least a part of vapor generated in the container. This semi-closed space can be formed in the container.

Fig. 3 is an illustrative diagram for illustrating arrangement when etching the semiconductor substrate 10, illustrating a step of transporting Si atoms and C atoms on the semiconductor substrate 10 side to the main container 30 side using a temperature difference provided between the semiconductor substrate 10 and the main container 30 as a driving force. That is, temperature of at least a part (for example, a bottom surface of the lower container 32) of the main container 30 becomes lower than that of the semiconductor substrate 10 due to the temperature gradient formed by the heating furnace, so that the driving force for transporting the Si atoms and C atoms on the semiconductor substrate 10 side to the main container 30 side is generated.

More specifically, it is heated in such a manner that, when temperature of the surface to be etched of the semiconductor substrate 10 is compared with temperature of the bottom surface of the lower container 32 facing this surface, the temperature on the semiconductor substrate 10 side is high and the temperature on the lower container 32 side is low. In this manner, by forming a space provided with a temperature difference between the semiconductor substrate 10 and the lower container 32 in the main container 30, the Si atoms and C atoms on the semiconductor substrate 10 side can be transported to the lower container 32 using the temperature difference as the driving force. Note that, although not illustrated, a substrate holder for holding the semiconductor substrate 10 can be provided, and the temperature gradient of the heating furnace can be reversed.

Fig. 4 is an illustrative diagram for illustrating arrangement when performing epitaxial growth on the semiconductor substrate 10, illustrating a step of transporting the Si atoms and C atoms on the main container 30 side to the semiconductor substrate 10 side using the temperature difference provided between the main container 30 and the semiconductor substrate 10 as the driving force. That is, temperature of at least a part (for example, a top surface of the upper container 31) of the main container 30 becomes higher than that of the semiconductor substrate 10 due to the temperature gradient formed by the heating furnace, so that the driving force for transporting the Si atoms and C atoms on the main container 30 side to the semiconductor substrate 10 side is generated.

More specifically, it is heated in such a manner that, when the temperature of the surface on which the epitaxial growth is performed of the semiconductor substrate 10 is compared with the temperature of the top surface of the upper container 31 facing this surface, the temperature on the semiconductor substrate 10 side is low and the temperature on the upper container 31 side is high. In this manner, by forming a space provided with a temperature difference between the semiconductor substrate 10 and the upper container 31 in the main container 30, the Si atoms and C atoms in the upper container 31 can be transported to the semiconductor substrate 10 using the temperature difference as the driving force. Note that, although not illustrated, a substrate holder for holding the semiconductor substrate 10 can be provided, and the temperature gradient of the heating furnace can be reversed.

### (Refractory Material Container 40)

The refractory material container 40 includes a refractory material. For example, C as a general-purpose heat-resistant member, W, Re, Os, Ta, and Mo as refractory metals, Ta₉C₈, HfC, TaC, NbC, ZrC, Ta₂C, TiC, WC, and MoC as carbides, HfN, TaN, BN, Ta₂N, ZrN, and TiN as nitrides, HfB₂, TaB₂, ZrB₂, NB₂, and TiB₂ as borides, polycrystalline SiC and the like can be exemplified.

Similarly to the main container 30, the refractory material container 40 is a fitting container including an upper container 41 and a lower container 42 that can be fitted to each other, and is configured to be able to house the main container 30. A minute gap 43 is formed in a fitting portion between the upper container 41 and the lower container 42, and it is configured that the inside of the refractory material container 40 can be exhausted (evacuated) from the gap 43. That is, it is configured that the inside of the refractory material container 40 is a semi-closed space at the time of exhaust.

The refractory material container 40 includes a Si-vapor supply source 44 capable of supplying a vapor pressure of gas phase species containing the Si element into the refractory material container 40. It is only required that the Si-vapor supply source 44 is configured to generate Si vapor in the refractory material container 40 at the time of heat treatment, and solid Si (Si pellet such as a single crystal Si piece or Si powder) and a Si compound can be exemplified. For example, a layer obtained by silicidation of the refractory material may be provided inside the above-described refractory material container 40.

In addition, any configuration can be adopted as long as the vapor pressure of the gas phase species containing the Si element is formed in the refractory material container 40 at the time of heat treatment.

### <Example 1>

A (0001) surface (= Si surface) of a semiconductor substrate 10 was etched so that an etching depth ED was 6.0 µm, and then crystal growth was performed so that a growth amount was 14.0 um. Thereafter, in-growth stacking faults IGSFs were measured by a PL method.

### (Etching Step)

At an etching step according to Example 1, the cut out semiconductor substrate 10 was housed in a main container 30, and the main container 30 was further housed in a refractory material container 40 and heated to 1,800°C using a heating furnace, so that the (0001) surface (= Si surface) of the semiconductor substrate 10 was etched by 6.0 um (refer to Fig. 3).

### (Crystal Growth Step)

At a crystal growth step according to Example 1, the semiconductor substrate 10 subjected to the etching step was housed in the main container 30, and the main container 30 was further housed in the refractory material container 40 and heated to 1,800°C using the heating furnace, so that the crystal growth was performed on the (0001) surface (= Si surface) of the semiconductor substrate 10 by 14.0 um (refer to Fig. 4).

### (Measurement Step)

At a measurement step according to Example 1, the semiconductor substrate 10 subjected to the crystal growth step was measured by the PL method (incident light: 313 nm, detector: > 750 nm). From a PL image of Example 1, no in-growth stacking faults IGSFs were observed. Therefore, density of the in-growth stacking faults IGSFs is 0 faults/cm², and it is considered that a subsurface damaged layer 11 of the semiconductor substrate 10 is removed.

### <Comparative Example 1>

A (0001) surface (= Si surface) of a semiconductor substrate 10 cut out from the same wafer of Example 1 was etched so that an etching depth ED was 1.3 µm, and then crystal growth was performed so that a growth amount was 14.0 um. Thereafter, in-growth stacking faults IGSFs were measured by a PL method.

### (Etching Step)

At an etching step according to Comparative Example 1, the cut out semiconductor substrate 10 was housed in a main container 30, and the main container 30 was further housed in a refractory material container 40 and heated to 1,700°C using a heating furnace, so that the (0001) surface (= Si surface) of the semiconductor substrate 10 was etched by 1.3 µm.

### (Crystal Growth Step)

At a crystal growth step according to Comparative Example 1, crystal growth was performed under the condition similar to that in Example 1.

### (Measurement Step)

At a measurement step according to Comparative Example 1, measurement was performed by the PL method under the condition similar to that in Example 1. Density of the in-growth stacking faults IGSFs obtained from a PL image of Comparative Example 1 was 2.5 faults/cm².

### <Comparative Example 2>

A (0001) surface (= Si surface) of a semiconductor substrate 10 cut out from the same wafer of Example 1 was etched so that an etching depth ED was 0.6 um, and then crystal growth was performed so that a growth amount was 14.0 um. Thereafter, in-growth stacking faults IGSFs were measured by a PL method.

### (Etching Step)

At an etching step according to Comparative Example 2, the cut out semiconductor substrate 10 was housed in a main container 30, and the main container 30 was further housed in a refractory material container 40 and heated to 1,700°C using a heating furnace, so that the (0001) surface (= Si surface) of the semiconductor substrate 10 was etched by 0.6 µm.

### (Crystal Growth Step)

At a crystal growth step according to Comparative Example 2, crystal growth was performed under the condition similar to that in Example 1.

### (Measurement Step)

At a measurement step according to Comparative Example 2, measurement was performed by the PL method under the condition similar to that in Example 1. Density of the in-growth stacking faults IGSFs obtained from a PL image of Comparative Example 2 was 13.5 faults/cm².

### <Comparative Example 3>

Crystal growth was performed on a (0001) surface (= Si surface) of a semiconductor substrate 10 cut out from the same wafer of Example 1 so that a growth amount was 14.0 um. That is, the crystal growth was performed on a CMP finished surface without etching. Thereafter, in-growth stacking faults IGSFs were measured by a PL method.

### (Crystal Growth Step)

At a crystal growth step according to Comparative Example 3, crystal growth was performed under the condition similar to that in Example 1.

### (Measurement Step)

At a measurement step according to Comparative Example 3, measurement was performed by the PL method under the condition similar to that in Example 1. Density of the in-growth stacking faults IGSFs obtained from a PL image of Comparative Example 3 was 32.0 faults/cm².

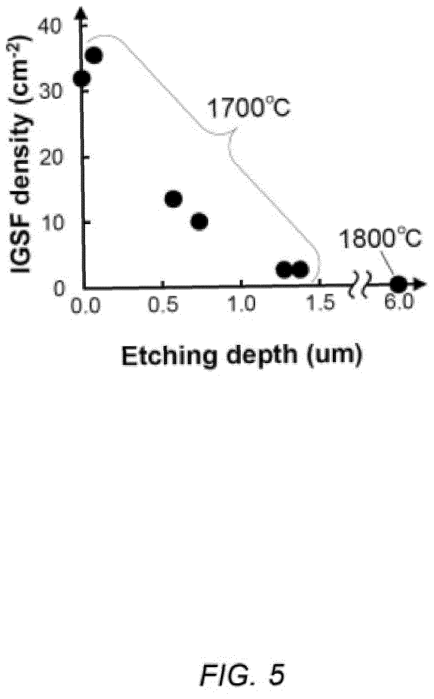

Fig. 5 is a graph illustrating a relationship between the in-growth stacking faults IGSFs and an etching depth ED according to the example and comparative examples.

As illustrated in Fig. 5, the density of the in-growth stacking faults IGSFs in the semiconductor substrate 10 subjected to the crystal growth step without the etching step was 32 faults/cm². In contrast, the density of the in-growth stacking faults IGSFs in the semiconductor substrate 10 subjected to the crystal growth step after the etching step was 13.5 faults/cm², 2.5 faults/cm², and 0 faults/cm², and it became apparent that the density of the in-growth stacking faults IGSFs decreases as the etching depth increases.

In Example 1, the density of the in-growth stacking faults IGSFs was 0 faults/cm², but it is considered to be excessive to perform the etching until the etching depth ED reached 6.0 µm.

In comparison with results of Example 1 and Comparative Example 1, when the etching depth ED is 1.5 um or more, it can be estimated that the growth layer 20 in which the in-growth stacking faults IGSFs are not formed can be obtained.

According to the example and comparative examples, it is considered that the subsurface damaged layer removal step S10 is only required to be a step of removing 1.5 um or more from the surface of the semiconductor substrate 10. It is considered that the subsurface damaged layer removal step S10 is only required to be a step of removing 6.0 um or more from the surface of the semiconductor substrate 10.

The example and comparative examples may be grasped as an evaluation method of the subsurface damaged layer including an evaluation step of evaluating the subsurface damaged layer 11 of the semiconductor substrate 10 on the basis of the in-growth stacking faults IGSFs formed during epitaxial growth on the semiconductor substrate 10.

The evaluation step may include the etching step of etching the subsurface damaged layer 11 of the semiconductor substrate 10, the crystal growth step of performing the crystal growth on the surface on which the subsurface damaged layer 11 is etched, and the measurement step of measuring the density of the in-growth stacking faults IGSFs at the crystal growth step.

At the evaluation step, the depth of the subsurface damaged layer 11 introduced into the semiconductor substrate 10 can be evaluated by performing measurement a plurality of times while changing the etching depth ED. Specifically, the depth of the subsurface damaged layer 11 can be estimated by including a first etching step of etching at a first etching depth and a second etching step of etching at a second etching depth.

That is, from the results of Example 1 and Comparative Example 1, the depth of the subsurface damaged layer 11 introduced into the semiconductor substrate 10 used this time (the wafer used this time) can be estimated to be about 1.5 um. Note that, the depth of the subsurface damaged layer 11 varies depending on the surface finish and quality of the wafer.

### Reference Signs List

- 10: Semiconductor substrate
- 11: Subsurface damaged layer
- 12: Bulk layer
- 20: Growth layer
- 30: Main container
- 31: Upper container

- 32: Lower container
- 33: Gap
- 40: Refractory material container
- 41: Upper container
- 42: Lower container
- 43: Gap
- 44: Si-vapor supply source
- S10: Subsurface damaged layer removal step
- S20: Crystal growth step
- ED: Etching depth
- IGSF: In-growth stacking faults

## Claims

1. A method for suppressing formation of stacking faults, the method comprising:
a subsurface damaged layer removal step of removing a subsurface damaged layer of a semiconductor substrate; and
a crystal growth step of performing crystal growth on a surface from which the subsurface damaged layer is removed.

2. The method according to claim 1, wherein the subsurface damaged layer removal step is a step of removing the subsurface damaged layer introduced by performing machining.

3. The method according to claim 1 or 2, wherein the subsurface damaged layer removal step is a step of etching the semiconductor substrate.

4. The method according to any one of claims 1 to 3, wherein the subsurface damaged layer removal step is a step of removing 1.5 um or more from the surface of the semiconductor substrate.

5. The method according to any one of claims 1 to 3, wherein the subsurface damaged layer removal step is a step of removing 6.0 um or more from the surface of the semiconductor substrate.

6. The method according to any one of claims 1 to 5, wherein the semiconductor substrate is silicon carbide.

7. A semiconductor substrate manufactured by the method according to claims 1 to 6.

8. A semiconductor device manufactured using the semiconductor substrate according to claim 7.

9. An evaluation method of a subsurface damaged layer, the method comprising: an evaluation step of evaluating a subsurface damaged layer of a semiconductor substrate based on in-growth stacking faults formed during epitaxial growth on the semiconductor substrate.

10. The method according to claim 9, wherein
the evaluation step includes:
an etching step of etching the subsurface damaged layer of the semiconductor substrate;
a crystal growth step of performing crystal growth on a surface on which the subsurface damaged layer is etched; and
a measurement step of measuring density of in-growth stacking faults at the crystal growth step.

11. The method according to claim 10, wherein the evaluation step is a step of performing measurement a plurality of times while changing an etching depth.

12. The method according to claim 10, wherein the etching step includes a first etching step of etching at a first etching depth and a second etching step of etching at a second etching depth.
